(19) Europäisches Patentamt

European Patent Office

Office européen des brevets

(11) **EP 1 477 818 A1**

(12) **EUROPEAN PATENT APPLICATION**

(43) Date of publication:
**17.11.2004 Bulletin 2004/47**

(51) Int Cl.⁷: **G01P 15/08**, G01P 1/02,
G01P 15/12

(21) Application number: **04011271.6**

(22) Date of filing: **12.05.2004**

| | |
|---|---|
| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK** | (71) Applicant: **HITACHI METALS, LTD.**<br>**Minato-ku, Tokyo (JP)** |
| | (72) Inventor: **Sakaguchi, Isao**<br>**Kodama-gun Saitama, 369-0306 (JP)** |
| (30) Priority: **12.05.2003 JP 2003132801** | (74) Representative: **Beetz & Partner Patentanwälte**<br>**Steinsdorfstrasse 10**<br>**80538 München (DE)** |

(54) **Acceleration sensor with IC chip acting as limit stop and signal processing circuitry**

(57) An acceleration sensor device with processing circuits constructed in an IC chip form is disclosed, and the IC chip and the acceleration sensor chip are integrated. The acceleration sensor device is constituted of an acceleration sensor chip constituted of elastic support arms (15), a mass portion (11) and a thick frame (14), a regulation plate (20) acting as stop member for restricting the movement of the mass portion, and a protection case (11). The regulation plate (20) is at the same time an IC chip having a processing circuit for electrically processing detected signals from the acceleration sensor chip, the IC chip also used as the regulation plate is disposed at an upper portion of the acceleration sensor chip with a predetermined gap (gl) from the acceleration sensor chip and electrically connected to the acceleration sensor chip via lead wires extending between bonding terminals, and the IC chip and the protection case are electrically connected to each other.

**FIG. 1**

EP 1 477 818 A1

**Description**

BACKGROUND OF THE INVENTION

1. Field of the Invention

The present invention relates to an acceleration sensor device for detecting acceleration, which is used for toys, automobiles, aircrafts, portable terminals and the like, and particularly to an acceleration sensor device that can be produced using a semiconductor technology.

2. Description of the Related Art

Acceleration sensors utilizing a change in physical quantity such as a piezo resistance effect and a change in electrostatic capacity have been developed and commercialized. These acceleration sensors can be widely used in various fields, but recently, such small-sized acceleration sensors as can detect the acceleration in multi-axial directions at one time with high sensitivity are demanded.

Since silicon single crystal is an ideal elastic body due to the extreme paucity of lattice defect and since a semiconductor process technology can be applied without large modification, much attention is paid to a piezo resistance effect type semiconductor acceleration sensor in which a thin elastic support portion is provided at a silicon single crystal substrate, and the stress applied to the thin elastic support portion is converted into an electric signal by a strain gauge, for example, a piezoresistor, to be an output.

As a three-dimensional acceleration sensor, an acceleration sensor has been used, which comprises elastic support arms each of a beam structure formed by a thin portion of a silicon single crystal substrate connecting a mass portion constituted by a thick portion of a silicon single crystal substrate in a center and a frame in its periphery. A plurality of strain gauges are formed in each axial direction on the elastic support arms. In order to sense a small acceleration with an enhanced sensitivity, the elastic support arms are made long and/or thin, or the mass portion that works as a pendulum is made heavy. The acceleration sensor that can detect a small acceleration has led to an excessive amplitude of the mass portion, when subjected to a large impact, and resulted to break the elastic support arms. To avoid the break of the elastic support arms even if a massive impact is applied, regulation plates have been installed above and below the acceleration sensor chip to restrict amplitude of the mass portion within a certain range.

Japanese Laid-Open Patents HEI 4-274005 (JP 04-274005 A) and HEI 8-233851 (JP 08-233851 A) disclose a method in which, to control a gap at a predetermined value between the regulation plates and the mass portion of the acceleration sensor chip, small balls having a diameter of substantially the same distance as a gap are mixed with adhesive, and the adhesive with small balls mixed is used to bond the regulation plates to the acceleration sensor chip. The gap can be maintained at a predetermined value because the gap between the regulation plates and the acceleration sensor chip can be dictated by a diameter of small balls. The use of adhesive containing small balls thus enables the control of a gap between the regulation plates and the acceleration sensor chip.

The acceleration sensor outputs DC voltage signals proportional to the acceleration, and the output voltages are as small as several mV to several tens mV. Therefore, it is necessary to include a circuit for amplifying the output voltages to correspond to an application field of a wide range. An acceleration sensor device, in which an IC chip having an amplification circuit or the like is mounted on a substrate with the acceleration sensor, is used, as described in Japanese Laid-Open Patent 2003-28891 (JP 2003-28891 A).

In a piezo resistance effect type semiconductor acceleration sensor, an output voltage when the acceleration is not applied (hereinafter, called "offset voltage") sometimes varies, and sensitivity of the output voltage with respect to the acceleration (hereinafter, called "output sensitivity") sometimes varies. Also, characteristics of the output voltage (hereinafter, called "output temperature characteristics") sometimes changes in accordance with the environmental temperature. In order to measure the acceleration with high accuracy, it is necessary to mount a compensation circuit for compensating the variations in the offset voltage, the output sensitivity and the output temperature characteristics to the acceleration sensor together with the amplification circuit.

Processing circuits for amplification, compensation and the like can be accommodated in a single IC chip, but if the acceleration sensor device is constructed by mounting both the IC of the processing circuits and the acceleration sensor on a substrate, the mounting area and volume of the acceleration sensor device become large. Therefore, it is difficult to provide an acceleration sensor device having a compact and thin structure resistant to the impact at the time of falling, which is required when loaded on a portable terminal and the like.

SUMMARY OF THE INVENTION

The present invention has its object to provide an acceleration sensor device with processing circuits being constructed in an IC chip form and the IC chip and the acceleration sensor chip being integrated, which is enabled to be compact and thin, excellent in impact resistance, high in reliability, with high accuracy and high sensitivity.

An acceleration sensor device of the present invention comprises: an acceleration sensor chip having a mass portion located in the center of the acceleration sensor chip, a thick frame surrounding the mass portion at a distance from the mass portion, a plurality of elastic support arms bridging an upper surface of the mass portion and an upper surface of the thick frame, and strain gauges formed on upper surfaces of the elastic support arms; an upper regulation plate mounted with a predetermined gap between the upper surface of the mass portion and a lower surface of the upper regulation plate to cover an upper surface of the acceleration sensor chip and bonded and fixed on the upper surface of the thick frame by paste; and a protection case accommodating the acceleration sensor chip. The acceleration chip has the upper regulation plate on the acceleration sensor chip, and a lower surface of the thick frame is bonded and fixed on an inner bottom plate of the protection case with a certain gap between the bottom plate and the mass portion lower surface. The upper regulation plate is an IC chip having an IC circuit for processing signals detected by the strain gauges, and terminals for the IC circuit on the upper regulation plate. The acceleration sensor chip has terminals for the strain gauges, formed on the thick frame and electrically connected to some of the terminals of the processing circuit on the upper regulation plate by a plurality of first lead wires or first conductors. The protection case has terminals, formed on the protection case and electrically connected to some of the terminals of the processing circuit on the upper regulation plate by a plurality of second lead wires or second conductors.

It is preferable that the upper regulation plate is made of a silicon substrate, on which the IC circuit for processing the detected signals is formed, in the aforesaid acceleration sensor device according to the present invention. It is further preferable that the upper regulation plate has an insulating layer formed on a surface facing the acceleration sensor chip in the acceleration sensor device of the present invention. Alternatively, an insulating layer may be formed on the upper surface of the acceleration sensor chip, namely, a surface facing the upper regulation plate.

It is preferable that the predetermined gap between the upper regulation plate and the upper surface of the mass portion is 3 to 35 μm in the acceleration sensor device of the present invention. It is preferable that the gap between the bottom plate of the protection case and the lower surface of the mass portion is 3 to 35 μm. The number of the first lead wires is at least four and the number of the second lead wires is at least five, whereby heat generation during operation of the acceleration sensor device can be prevented.

The upper limit value of the gap between the upper regulation plate and the upper surface of the mass portion is determined to minimize an impact damage to the acceleration sensor and the temperature difference between the acceleration sensor chip and the IC chip under a practical power consumption. On the other hand, the lower limit value of the gap limits the range of the movement of the mass portion, thus setting the gap to be large in the acceleration sensor for measuring large acceleration, and setting the gap to be small in the highly sensitive acceleration sensor for measuring small acceleration because the strength of the elastic support arms is made small. It is desirable to set the gap between the bottom plate of the protection case and the lower surface of the mass portion to be 3 μm to 35 μm for the same reason.

As a conventional regulation plate, plates made of glass, ceramics or metal have been used to restrict the movement of a mass portion of a conventional acceleration sensor. In the present invention, the IC chip having the processing circuit essential for enhancement of accuracy is provided on the upper portion of the acceleration sensor chip, thereby giving two functions of signal processing and restriction of the gap to the upper regulation plate. According to the present invention, the highly accurate and compact acceleration sensor device can be realized while maintaining impact resistance without increasing the number of components. Since the IC chip can be made to be as thin as 0.3 mm thick or less by grinding a back surface of the IC chip without the electronic circuit, the thickness of the upper regulation plate can be approximately equivalent to the thickness of the conventional regulation plate. In spite of adding the processing circuit to the acceleration sensor, the acceleration sensor device in the same size as the conventional acceleration sensor can be realized.

In the acceleration sensor device of the present invention, the IC chip is located above the sensor chip with air gap, and therefore it is afraid that the generated heat from the IC chip cannot be released sufficiently. If the heat radiation performance is insufficient, the temperature inside the protection case rises and reduces the life time of the processing circuit, which becomes the problem from the aspect of the reliability. It is necessary to decrease the temperature difference between the acceleration sensor chip and the IC chip. To compensate the temperature, the output from the acceleration sensor is compensated by detecting the temperature of the acceleration sensor chip by a temperature sensor inside the IC chip, and therefore it is desirable that the temperature difference between the acceleration sensor chip and the IC chip is small. In order to make the temperature difference between the acceleration sensor chip and the IC chip small, it is preferable to use ceramics excellent in heat radiation performance for the protection case and the protection case lid. And also, it is preferable to use adhesive with high thermal conductivity for the adhesive for bonding the acceleration sensor chip and the IC chip, and to use gap control balls with high heat conductivity as the gap control balls mixed into the adhesive.

The gap between the acceleration sensor chip and the IC chip is made as small as possible, electrical connecting portions are provided between the acceleration sensor chip and the IC chip, and between the IC chip and the protection case, to transmit heat through the electrical connecting portions and release the heat outside by using a ceramic material having favorable heat releasing ability for the protection case, whereby the temperature difference between the acceleration sensor chip and the IC chip can be made small. Specifically, the gap between the acceleration sensor chip and the IC chip is set to be from 3 μm to 35 μm, the electrical connections between the acceleration sensor chip and the IC chip are set on at least four spots or more, the electrical connections between the IC chip and the protection case are set on at least five spots or more, and bare gold wires of a diameter of 20 μm or more are used for the electrical connections, whereby the heat resistance can be made 100°C/W or less. Since the power consumption in the actual use is estimated to be 30 mW at most, the temperature rise in the protection case can be restrained to be within about 3°C, which is within the workable level without a problem. Even when the power consumption is 30 mW, the temperature difference between the acceleration sensor chip and the IC chip can be made 2°C or less.

BRIEF DESCRIPTION OF THE DRAWINGS

FIG. 1 is an exploded perspective view of an acceleration sensor device of the present invention;
FIG. 2 is a perspective view of an acceleration sensor chip used for the acceleration sensor device of the present invention;
FIG. 3 is a sectional view taken along the line III-III in FIG. 1;
FIG. 4 is a plan view of the acceleration sensor device of the present invention after bare gold wires are connected;
FIG. 5 is a plan view of an acceleration sensor device of the present invention, modified from the acceleration sensor device shown in FIG. 4, after the bare gold wires are connected;
FIG. 6 is a graph showing results of measuring the temperature of an IC chip and the temperature of the acceleration sensor chip; and
FIG. 7 is a graph showing the temperature difference between the IC chip and the acceleration sensor chip with respect to the power consumption in the acceleration sensor device of the present invention.

DETAILED DESCRIPTION OF THE PREFERRED EMBODIMENTS

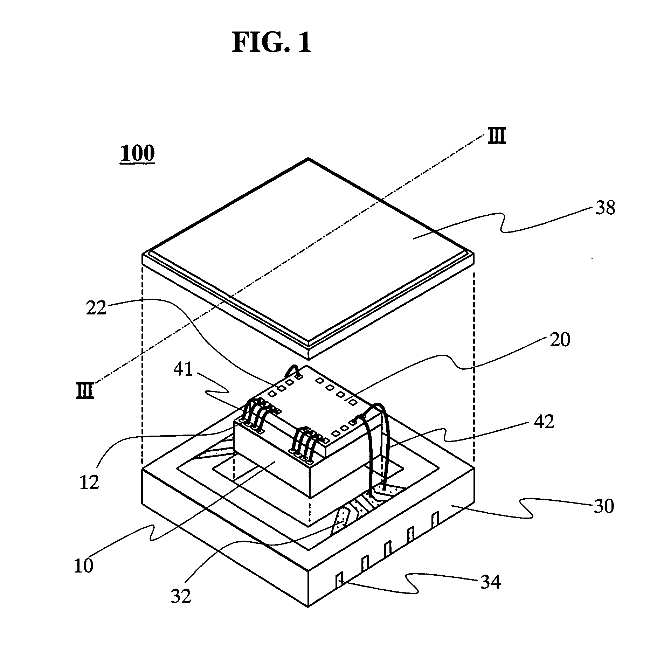

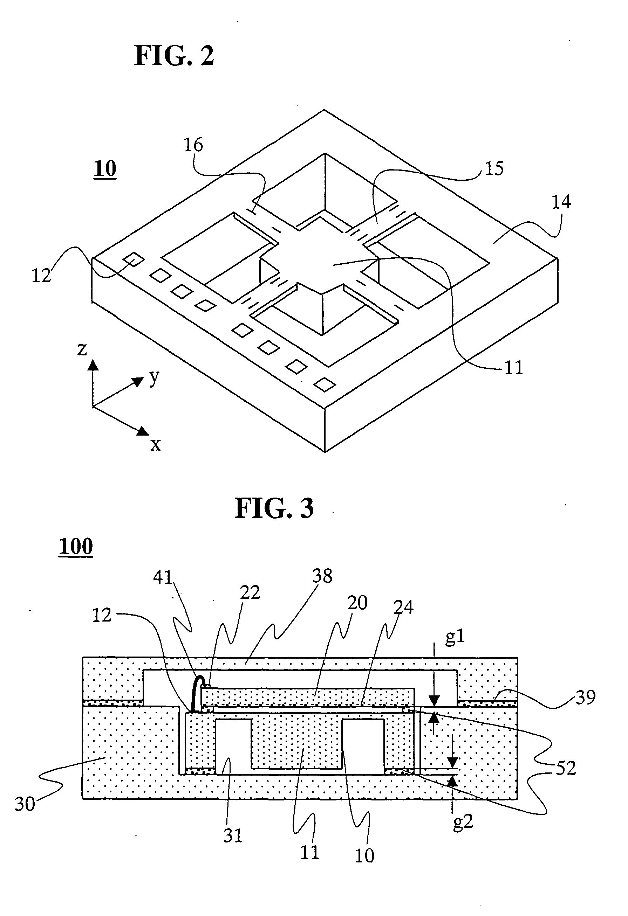

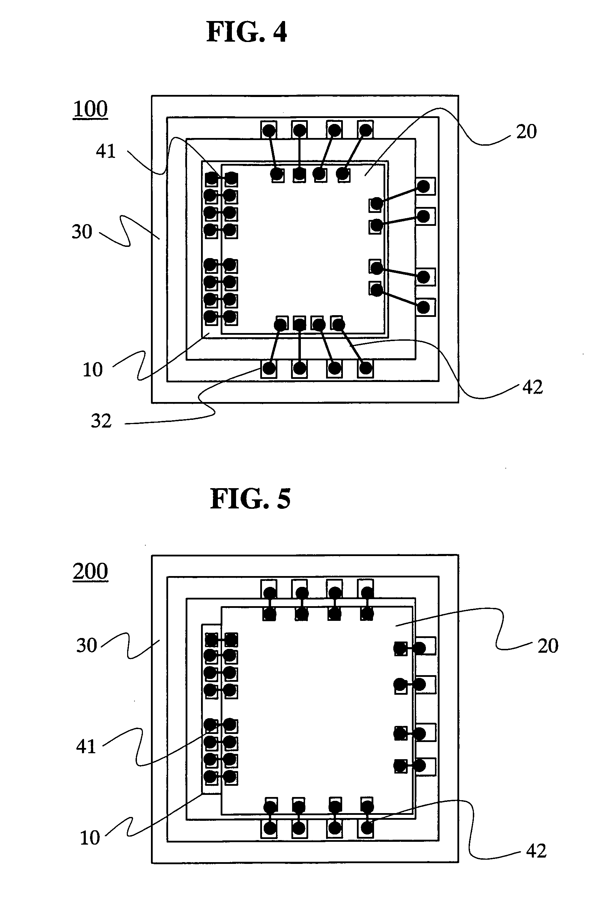

An embodiment of an acceleration sensor device of the present invention will be explained, referring to FIGS. 1 to 4. FIG. 1 shows an exploded perspective view of the acceleration sensor device of the present invention, FIG. 2 shows a perspective view showing an acceleration sensor chip used in the acceleration sensor device of the present invention, and FIG. 3 shows a sectional view taken along the line III-III in FIG. 1. FIG. 4 is a plan view of the acceleration sensor device shown in FIG. 1 with a lid being removed. In the acceleration sensor device 100 of the present invention, an IC chip 20 is bonded onto a top surface of an acceleration sensor chip 10 with its circuit mounting surface up by using an adhesive 52 mixed with hard plastic balls, and the acceleration sensor chip 10 is inserted into and bonded to a protection case 30. When the acceleration sensor chip 10 is bonded in the protection case 30, the adhesive 52 mixed with the hard plastic balls is previously coated onto a bonding region on a bottom surface 31 of the protection case. The adhesive 52 is prepared by mixing the hard plastic balls each having a diameter of 15 μm in a silicon resin by about 10 wt%. A gap g1 between the IC chip 20 and the acceleration sensor chip 10, and a gap g2 between the bottom surface 31 in the protection case and the acceleration sensor chip 10 are precisely maintained to be 15 μm by the hard plastic balls.
The acceleration sensor chip 10 for the present invention uses a silicon single crystal substrate with an SOI layer being formed via a $SiO_2$ insulation layer, namely, an SOI wafer, in order to make it possible to control the thickness of elastic support arms 15 with high precision. The SOI is an abbreviation of Silicon On Insulator. In this example, a wafer formed by thinly forming the $SiO_2$ insulation layer being an etching stopper (about 1 μm) on a Si wafer with thickness of about 600 μm, on which an N-type silicon single crystal layer with thickness of about 7 μm is formed, is used as a substrate. The acceleration sensor chip 10 is constituted by a mass portion 11 in a center, which is constituted by a thick portion of the silicon single crystal substrate; a square-shaped frame 14 placed around the mass portion 11 to surround it; two pairs of beam-shaped elastic support arms 15 that are constituted by thin portions of the silicon single crystal substrate to connect the mass portion 11 and the frame 14, strain gauges (in the following explanation, "piezoresistors" as an example of the strain gauges are used, and therefore they are called "piezoresistors") 16, four of which are for each axis, and which are placed on the elastic support arms correspondingly to two detection axes (X and Y axes) perpendicular to each other and the detection axis (Z axis) orthogonal to the top surface of the acceleration sensor chip. Namely, the two piezoresistors 16 are provided on each of the elastic support arms 15, which extend in the X-axis direction to detect the acceleration in the X-axis direction. The two piezoresistors 16 are provided on each of the elastic support arms 15, which extend in the Y-axis direction to detect the acceleration in the Y-axis direction. Further two piezoresistors 16 are provided on each of the elastic support arms 15, which extend in the Y-axis direction to detect the acceleration in the Z-axis direction. In this example, the acceleration in the Z-axis direction is detected by the piezoresistors provided on the elastic support arms 15 extending in the Y-axis direction, but the elements for detecting the acceleration in the Z-axis direction may be provided on the elastic support arms 15 extending in the X-axis direction. Four of the piezoresistors for detecting the acceleration in each axis direction construct a full bridge detection circuit. The piezoresistors are formed by patterning the surface (the silicon layer of 7 $\mu$m thick) of the SOI wafer with a photo-resist and by bombarding the silicon layer with boron atoms of 1 to 3 x $10^{18}$ atoms/cm$^3$ in density. Circuits for the piezoresistors are formed on the wafer by metal-sputtering, dry-etching and the like.

A plurality of input/output terminals 12 for piezoresistors are provided on the upper surface of the thick frame 14 of the acceleration sensor chip 10. The input/output terminals 12 are preferably aligned along a side of the acceleration sensor chip 10 for convenience of wiring and connected to terminals of twelve piezoresistors on the elastic support arms by each of conductors provided from the upper surfaces of the elastic support arms to the upper surface of the thick frame. FIG. 2 does not show these conductors that connect the input/output terminals 12 to the piezoresistors 16.

An IC chip 20 is mounted to cover the upper surface of the acceleration sensor chip 10. A predetermined gap, for example a gap g1 of 3 to 35 $\mu$m, is provided between the lower surface of the IC chip 20 and the upper surface of the mass portion 11 of the acceleration sensor chip 10. The upper surface of the thick frame 14 of the acceleration sensor chip 10, which is a square thick frame in this embodiment, is fixed at each corner to the IC chip 20 with paste 52.

The mass portion 11 of the acceleration sensor chip 10 has the predetermined gap g1 with the lower surface of the IC chip 20 on the upper surface of the mass portion. When an acceleration is applied to the acceleration sensor chip 10 from outside, the mass portion 11 is moved but the displacement of the mass portion 11 is restricted within the gap g1. The IC chip 20 works as an upper regulation plate.

SiO$_2$ layer is formed on a lower surface of the IC chip 20 as an insulating layer 24. Since the mass portion 11 of the acceleration sensor chip 10 sometimes contacts or collides against the lower surface of the IC chip 20 when the acceleration works on the acceleration sensor device, the insulating layer is provided to prevent leakage of an electric charge to the acceleration sensor chip from the bottom surface of the IC chip. Al$_2$O$_3$ layer may be used as the insulating layer 24 instead of the SiO$_2$ layer. Alternatively, an insulating layer may be provided on the upper surface of the acceleration sensor chip instead of the insulating layer on the bottom surface of the IC chip.

The terminals 12 for piezoresistors are provided on an upper surface of one side of the thick frame 14 of the acceleration sensor chip 10. Since three sets (one set for each of the X, Y and Z axes) of full bridge detection circuits are constructed by twelve piezo resistors 16 provided on the acceleration sensor chip, at least four terminals 12 are needed, and eight terminals 12 are preferably provided on the upper surface of the thick frame 14. Each of these terminals 12 is electrically connected to each of some of processing circuit terminals 22 provided at the IC chip 20 by lead wires 41 (sometimes called "a first lead wire"). As the first lead wire 41, for example, bare gold wires of 0.5 mm long and 20 $\mu$m diameter may be used. One end of each of the bare gold wires is welded to the respective terminal 12, and the other end of the bare gold wires is welded to the respective processing circuit terminal 22, by an ultrasonic bonder.

A protection case 30 has a side frame and an inner bottom plate 31, and a lower surface of the thick frame of the acceleration sensor chip 10 is fixedly bonded onto the inner bottom plate 31. When the acceleration sensor chip 10 is fixed to the inner bottom plate 31, the mass portion 11 in the center of the acceleration sensor chip 10 is not contacted with the bottom plate 31 of the protection case 30 and maintains a predetermined gap g2, which may be different in length from the gap g1 between the upper surface of the mass portion and the upper regulation plate. The inner bottom plate 31 maintains a certain gap from the lower surface of the mass portion 11 and restricts the downward vibration within the gap, acting as a lower regulation plate.

The side frame of the protection case 30 has a plurality of input/output terminals 32, and each of some of the terminals 22 of the IC chip 20 is electrically connected to these input/output terminals 32 by lead wires 42, which may be called "second lead wires". Each of the input/output terminals 32 is in turn connected to a plurality of external terminals 34 provided on side surfaces of the protection case 30 by conductors (not shown) in the side frame. The protection case 30 has at least five input/output terminals 32. They are preferably twelve. Bare gold wires of 20 $\mu$m diameter are used for the second lead wires 42 electrically connecting each of the twelve terminals 32 with the terminals 22 of the IC chip and welded at their ends to each of the terminals by an ultrasonic bonder. The protection case 30, which is made of for example alumina ceramic, is fixed to a lid of alumina ceramic with adhesive 39 on the case.

The size of the acceleration sensor chip will now be described. The length of a side of the square acceleration sensor chip 10 is approximately 2200 $\mu$m, and the thick frame 14 has a thickness of 600 $\mu$m and a width of 300 $\mu$m. The mass portion 11 in the center has a side of approximately 600 $\mu$m in length, and a thickness of 600 $\mu$m. Four elastic support arms 15 have a length of 500 $\mu$m and a width of 90 $\mu$m, and since they are made of silicon on SiO$_2$ insulation layer, they have a thickness of approximately 7 $\mu$m.

The processing circuit in the IC chip also having a function as a regulation plate is constructed by a multiplexer for switching input axes, an operation amplifier for amplifying signals, an EEPROM for storing correction data, a temperature sensor for detecting environmental temperature, a resistance rudder having a function of giving an adjustment code from the EEPROM based on the output of the temperature sensor and feeding back the gain and offset of the operation amplifier, and the like. The size of the IC chip is 1.9 mm wide × 2.2 mm long × 0.2 mm thick to be able to draw out the lead wires from the acceleration sensor chip and to avoid the one side of the acceleration chip having pad portions (terminals) to let the lead wires from the acceleration sensor chip pass to the IC chip.

FIG. 4 shows a plan view of the acceleration sensor device 100 before a protection case lid 38 is mounted, in which the acceleration sensor chip 10 bonded with the IC chip 20 is mounted in the protection case 30 and the first and the second lead wires 41 and 42 are connected among them. In this example, the IC chip 20 has the size which does not protrude out of the sensor chip 10 when the IC chip 20 is overlaid on the sensor chip 10 as shown in FIG. 4. However, as a plan view of a modified acceleration sensor device 200 shown in FIG. 5, the IC chip 20 may protrude in part out of the sensor chip 10.

An external dimension of the produced acceleration sensor device of the present invention of 4.8 mm square, and 1.3 mm thick, which is approximately the same as a conventional acceleration sensor, was realized in spite of adding the amplifier and the processing circuit functions of the temperature compensation and the like to the sensor device.

Experiment

100 acceleration sensor devices of the present invention were produced, and the impact test was conducted to them by a pendulum type impact testing machine. During applying the acceleration of 20G to the acceleration sensor devices with a vibration machine, the output V1 was measured before the impact test, and then the impact acceleration of 5000 G was applied to them with the pendulum type impact testing machine. The output V2 was measured when applying the acceleration of 20G again after the impact test. It was determined that the acceleration sensors after subjected to the impact were broken when the output V2 was reduced by more than 5 % of the output V1. As a result, no acceleration sensor devices were broken at the impact acceleration of 5000 G. The acceleration of 5000 G corresponds to an impact at the time of naturally falling onto a concrete floor from the falling height of 1.5 m, and it was proved that the IC chip functioned as a regulation plate for preventing the breakage of the elastic support arms of the acceleration sensor chip.

In order to confirm heat radiation performance, heat resistance was measured. The IC chip temperature was measured by monitoring the output of a temperature sensor contained in the IC. Temperature conversion of the temperature sensor output to temperature was performed by a correlation formula between the environment temperature and the temperature sensor output obtained by putting the acceleration sensor device into an electric oven. The measurement of the temperature of the acceleration sensor chip was carried out by utilizing the temperature dependency of the resistance of the piezoresistors and measuring the resistance. The temperature conversion from the resistance was performed by putting the acceleration sensor device into the electric oven and obtaining a correlation formula between the environment temperature and the resistance.

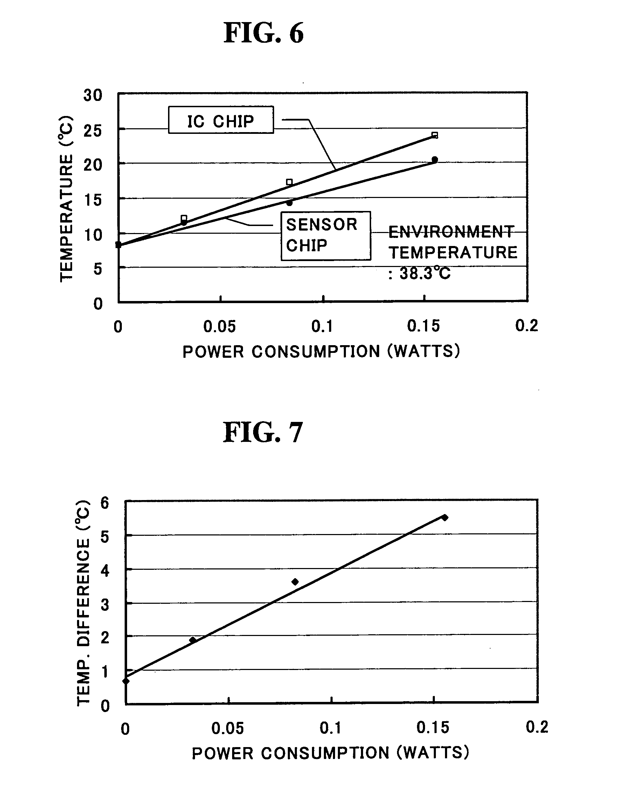

FIG. 6 shows the measurement results of the power consumption and the IC chip temperature, and the acceleration sensor chip temperature. The temperature rise of the IC chip is obtained from the gradient of the graph of.

$$(Temperature) = 99.04 \cdot (power\ consumption) + 38.444, \text{ and it was } 99°C \text{ per 1 W.}$$

Namely, the heat resistance of the acceleration sensor device of this embodiment is 99°C, and the temperature rise at the power consumption of 30 mW which is in a real use, is estimated to be about 3°C. FIG. 7 shows the temperature difference between the IC chip and the acceleration sensor chip. The more the power consumption, the larger the temperature difference between the IC chip and the acceleration sensor chip, and the temperature difference was 2°C or less at the power consumption of 30 mW. The temperature rise of the IC chip was 3°C, and the temperature difference of 2°C or less between the IC chip and the acceleration sensor chip, which is no problem in real use, can be achieved.

As explained above, according to the present invention, the amplifier and the compensation circuit which are essential for enhancing the precision of the acceleration sensor are added, and it is made possible to provide the compact and thin acceleration sensor device with the processing circuit being added with high reliability, which is loadable on a portable terminal or the like and resistant to the impact at the time of falling.

**Claims**

1. An acceleration sensor device comprising:

an acceleration sensor chip (10-16) having

a mass portion (11) located in the center of the acceleration sensor chip,

a thick frame (14) surrounding the mass portion and being at a distance from the mass portion (11),

a plurality of elastic support arms (15) bridging an upper surface of the mass portion and an upper surface of the thick frame (14), and

strain gauges (16) formed on upper surfaces of the elastic support arms;

an upper regulation plate (20) mounted with a predetermined gap (g1) between the upper surface of the mass portion and a lower surface of the upper regulation plate to cover the acceleration sensor chip (10 - 16) and fixed on the upper surface of the thick frame by paste (52); and

a protection case (30, 38) enveloping the acceleration sensor chip;

wherein the upper regulation plate (20) is an IC chip having an IC circuit for processing signals detected by the strain gauges and terminals (22) for the IC circuit on the upper regulation plate,

the acceleration sensor chip has terminals (11) for the strain gauges, formed on the thick frame (14) and electrically connected to some of the terminals (22) on the upper regulation plate by a plurality of first lead wires (41), and

the protection case (30, 38) has terminals (32) on the protection case, electrically connected to some of the terminals on the upper regulation plate by a plurality of second lead wires (42).

2. An acceleration sensor device as set forth in claim 1, wherein the upper regulation plate (20) is made of a silicon substrate, on which the IC circuit for processing the detected signals is formed.

3. An acceleration sensor device as set forth in claim 1, wherein the predetermined gap (g1) between the regulation plate and the upper surface of the mass portion is 3 to 35 $\mu$m.

4. An acceleration sensor device as set forth in claim 2 or 3, wherein the number of the first lead wires (41) is at least four and the number of the second lead wires (42) is at least five.

# FIG. 1

## FIG. 2

## FIG. 3

# FIG. 4

# FIG. 5

# FIG. 6

# FIG. 7

# EP 1 477 818 A1

**European Patent Office**

## EUROPEAN SEARCH REPORT

Application Number

EP 04 01 1271

| | DOCUMENTS CONSIDERED TO BE RELEVANT | | | |
|---|---|---|---|---|
| Category | Citation of document with indication, where appropriate, of relevant passages | Relevant to claim | CLASSIFICATION OF THE APPLICATION (Int.Cl.7) | |
| X | PATENT ABSTRACTS OF JAPAN vol. 018, no. 627 (P-1834), 29 November 1994 (1994-11-29) -& JP 06 242141 A (TOKAI RIKA CO LTD), 2 September 1994 (1994-09-02) * abstract; figure 1 * | 1-4 | G01P15/08 G01P1/02 G01P15/12 | |
| X | US 6 435 028 B1 (NAGAHARA TERUAKI) 20 August 2002 (2002-08-20) * column 9, last paragraph - column 11, paragraph 2; figures 10-12 * | 1-4 | | |
| X | PATENT ABSTRACTS OF JAPAN vol. 1996, no. 05, 31 May 1996 (1996-05-31) -& JP 08 015300 A (TAKATA KK), 19 January 1996 (1996-01-19) * abstract * | 1-4 | | |
| A | US 5 864 062 A (OTANI HIROSHI ET AL) 26 January 1999 (1999-01-26) * figure 8 * | 4 | TECHNICAL FIELDS SEARCHED (Int.Cl.7) G01P | |
| A | US 5 895 853 A (SHIOTA KUNIHIRO) 20 April 1999 (1999-04-20) * column 2; claim 1; figures 1,9 * | 1 | | |
| A | US 5 567 880 A (YOKOTA YOSHIHIRO ET AL) 22 October 1996 (1996-10-22) * figure 1 * | 1 | | |

The present search report has been drawn up for all claims

| Place of search | Date of completion of the search | Examiner |
|---|---|---|
| Munich | 11 August 2004 | Felicetti, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

12

## ANNEX TO THE EUROPEAN SEARCH REPORT
## ON EUROPEAN PATENT APPLICATION NO.

EP 04 01 1271

This annex lists the patent family members relating to the patent documents cited in the above-mentioned European search report.
The members are as contained in the European Patent Office EDP file on
The European Patent Office is in no way liable for these particulars which are merely given for the purpose of information.

11-08-2004

| Patent document cited in search report | | Publication date | Patent family member(s) | | Publication date |
|---|---|---|---|---|---|
| JP 06242141 | A | 02-09-1994 | NONE | | |
| US 6435028 | B1 | 20-08-2002 | JP<br>DE | 2001235485 A<br>10054964 A1 | 31-08-2001<br>13-09-2001 |
| JP 08015300 | A | 19-01-1996 | NONE | | |
| US 5864062 | A | 26-01-1999 | JP<br>JP<br>DE | 3278363 B2<br>10148642 A<br>19727214 A1 | 30-04-2002<br>02-06-1998<br>20-05-1998 |
| US 5895853 | A | 20-04-1999 | JP<br>JP | 2658949 B2<br>8233851 A | 30-09-1997<br>13-09-1996 |
| US 5567880 | A | 22-10-1996 | JP<br>JP<br>DE<br>DE | 2776142 B2<br>5312829 A<br>4316279 A1<br>9320965 U1 | 16-07-1998<br>26-11-1993<br>18-11-1993<br>06-07-1995 |

EPO FORM P0459

For more details about this annex : see Official Journal of the European Patent Office, No. 12/82